# EUROPEAN PATENT APPLICATION

(11) **EP 4 800 075 A1**
(43) Date of publication of application: **02.09.2026**
(21) Application number: 24882255.3
(22) Date of filing: 16.10.2024
(51) Int. Cl.: C08L 81/02, C08F 290/14, C08G 75/029, C08J 5/24, C08K 3/013, C08K 5/14, C08L 25/04, H05K 1/03

(54) **RESIN COMPOSITION CONTAINING SUBSTITUTED POLYPHENYLENE SULFIDE RESIN**

(30) Priority: 23.10.2023 JP 2023182106
(71) Applicant: Daicel Corporation, Osaka-shi, Osaka 530-0011 (JP)
(72) Inventor: ITO, Daisuke, 108-8230 Tokyo (JP); ISHIKAWA, Shinsuke, 108-8230 Tokyo (JP)
(74) Representative: Grünecker Patent- und Rechtsanwälte PartG mbB
(86) International application number: PCT/JP2024/036743
(87) International publication number: WO 2025/089142

(57) **Abstract**

Provided is a resin composition having a low dielectric loss tangent and a low thermal expansion coefficient. The resin composition contains: a substituted polyphenylene sulfide resin (A) that contains a structural unit represented by General Formula (I) where R₁, R₂, R₃, and R₄ are each independently H, an alkyl group, an alkoxy group, an aryl group, or an alkenyl group-containing organic group, and one or more of R₁, R₂, R₃, and R₄ are an alkyl group or an alkoxy group; and a filler (B).

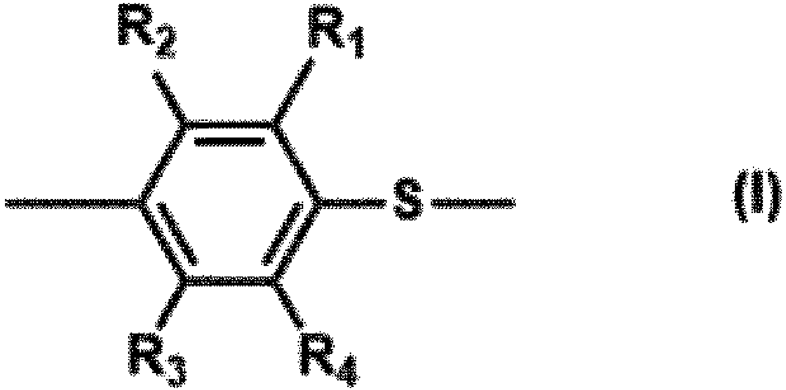

## Description

### Technical Field

The present disclosure relates to a resin composition containing a substituted polyphenylene sulfide resin.

### Background Art

In recent years, high-speed and large-capacity mobile communication systems have been developed. With the progress of such mobile communication systems, higher frequency bands have been used for communication. For example, in the fifth generation mobile communication system, which has already started to be put into practical use, a frequency band higher than that of the fourth generation or earlier mobile communication systems is used.

In a terminal of a mobile communication system, attenuation of an electric signal through the circuit of a printed wiring board, so-called transmission loss, occurs. The transmission loss also depends on the dielectric characteristics of the substrate (dielectric) of the printed wiring board. In general, the higher the frequency used, the greater the influence on the dielectric loss tangent, resulting in greater transmission loss.

Suppression of transmission loss in a printed wiring board used for communication in a high frequency band is required for enabling higher-speed mobile communication. Therefore, a low transmission loss is also required for a resin or resin composition used as a material for a printed wiring board. A resin or resin composition with a low dielectric loss tangent is required to enable low transmission loss.

Typically, resin compositions containing a polyphenylene ether (PPE) resin (e.g., Patent Document 1) or an unsubstituted polyphenylene sulfide (PPS) resin as a main component have been used as materials for wiring boards such as printed wiring boards.

Patent Document 1: JP 2023-1134 A

### Summary of Invention

However, materials for wiring boards using a PPE resin or an unsubstituted PPS resin tend to have high dielectric loss tangents, and thus the transmission loss may increase in communication applications at high frequency bands. In addition, since the PPE resin itself has low flame retardancy, it is necessary to impart flame retardancy to the resin composition by mixing it with a flame retardant material to use it as a material for a wiring board.

The present inventors have found that a polyphenylene sulfide resin having a substituent (substituted PPS) can achieve a lower dielectric loss tangent than a PPE resin or an unsubstituted PPS resin. However, in laminating when the substituted PPS resin is used for a wiring board, the laminate is likely to warp because the thermal expansion coefficient of the substituted PPS resin is higher than that of other lamination materials.

An object of the present disclosure is to provide a resin composition having a low dielectric loss tangent and a low thermal expansion coefficient.

The present disclosure includes the following aspects.
[1] First Aspect
   [1-1] A resin composition including:
   a substituted polyphenylene sulfide resin (A) that includes a structural unit represented by General Formula (I): 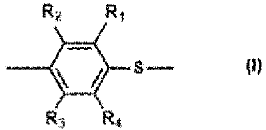
   where R₁, R₂, R₃, and R₄ are each independently H, an alkyl group, an alkoxy group, an aryl group, or an alkenyl group-containing organic group, and one or more of R₁, R₂, R₃, and R₄ are an alkyl group or an alkoxy group; and
   a filler (B).
| [2] Second Aspect
   [2-1] An article for a wiring board, the article containing the resin composition described in [1-1].
[3]Third Aspect
   [3-1] A wiring board containing the resin composition described in [1-1].
[4] Fourth Aspect
   [4-1] A printed wiring board containing the resin composition described in [1-1].

According to an embodiment of the present disclosure, it is possible to provide a resin composition having a low dielectric loss tangent and a low thermal expansion coefficient.

### Description of Embodiments

Hereinafter, an embodiment of the present disclosure will be described in detail, but each configuration, a combination of configurations, and the like in each embodiment are an example, and additions, omissions, substitutions, and other changes can appropriately be made without departing from the spirit of the present disclosure. Each aspect disclosed in the present specification can be combined with any other feature disclosed in the present specification. In a case where a plurality of upper limit values and lower limit values are described for a specific parameter, any upper limit value and any lower limit value among these upper limit values and lower limit values can be combined to obtain a suitable numerical range. A lower limit value and/or an upper limit value of a numerical range described in the present disclosure is a numerical value that is included within the numerical range and may be replaced with a numerical value presented in Examples. The expression "from X to Y" with regard to a numerical range means "X or more and Y or less". Where a particular description given for an embodiment also applies to another embodiment, that description may be omitted in the other embodiment.

### First Embodiment: Resin Composition

A resin composition according to the present embodiment (hereinafter, also simply referred to as "resin composition") contains:
a substituted polyphenylene sulfide resin (A) (hereinafter, also simply referred to as "substituted PPS resin (A)") that contains a structural unit represented by General Formula (I): 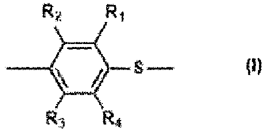
where R₁, R₂, R₃, and R₄ are each independently H, an alkyl group, an alkoxy group, an aryl group, or an alkenyl group-containing organic group, and one or more of R₁, R₂, R₃, and R₄ are an alkyl group or an alkoxy group; and
a filler (B).

Containing the substituted PPS resin (A) and the filler (B) enables a resin composition having a low dielectric loss tangent and a low thermal expansion coefficient. The term "low thermal expansion coefficient" means a thermal expansion coefficient lower than that in the case of curing the substituted PPS resin (A) alone. In one embodiment, the phrase "having a low thermal expansion coefficient" means that the thermal expansion coefficient is as low as that of other lamination materials in the wiring board. When the resin composition having a low thermal expansion coefficient is used as a material for a wiring board and the resin composition has a thermal expansion coefficient as low as that of other lamination materials such as metal foil, a laminate produced by laminating is less likely to warp. It has not been known that the filler (B) has an action of lowering the thermal expansion coefficient while maintaining the low dielectric loss tangent property of the substituted PPS resin (A).

### Substituted Polyphenylene Sulfide Resin (A)

A substituted PPS resin (A) contains a structural unit represented by General Formula (I): 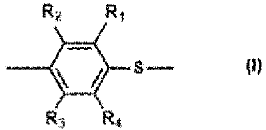 where R₁, R₂, R₃, and R₄ are each independently H, an alkyl group, an alkoxy group, an aryl group, or an alkenyl group-containing organic group (preferably H, an alkyl group, an alkoxy group, or an alkenyl-group containing organic group), and one or more of R₁, R₂, R₃, and R₄ are an alkyl group or an alkoxy group. The contained structural unit represented by General Formula (I) may be composed of one type or two or more types with different types and numbers of substituents.

The alkyl group may be a linear, branched, or cyclic alkyl group, and is preferably a linear, branched, or cyclic alkyl group having from 1 to 10 carbons. Examples of the linear, branched, or cyclic alkyl group having from 1 to 10 carbons include a methyl group, an ethyl group, an n-propyl group, an isopropyl group, an n-butyl group, a tert-butyl group, an s-isobutyl group, an n-pentyl group, an isopentyl group, a neopentyl group, an n-hexyl group, an isohexyl group, an n-heptyl group, an n-octyl group, an isooctyl group, an n-nonyl group, an isononyl group, an n-decyl group, an isodecyl group, a cyclopropyl group, a cyclobutyl group, a cyclopentyl group, a cyclohexyl group, a cycloheptyl group, and a cyclooctyl group. The contained alkyl group may be composed of one type or two or more types.

In one embodiment, the alkyl group is preferably a methyl group, an ethyl group, and/or an isopropyl group.

The alkoxy group may be a linear, branched, or cyclic alkoxy group, and is preferably a linear, branched, or cyclic alkoxy group having from 1 to 10 carbons. Examples of the linear or branched alkoxy group having from 1 to 10 carbons include a methoxy group, an ethoxy group, an n-propoxy group, an isopropoxy group, an n-butoxy group, a tert-butoxy group, an s-butoxy group, an isobutoxy group, an n-pentyloxy group, an isopentyloxy group, a neopentyloxy group, an n-hexyloxy group, an isohexyloxy group, an s-hexyloxy group, a tert-hexyloxy group, a neohexyloxy group, an n-heptyloxy group, an n-octyloxy group, an isooctyloxy group, an n-nonyloxy group, an isononyloxy group, an n-decyloxy group, an isodecyloxy group, a cyclopropoxy group, a cyclobutoxy group, a cyclopentyloxy group, a cyclohexyloxy group, a cycloheptyloxy group, a cyclooctyloxy group, a cyclononyloxy group, and a cyclodecyloxy group. The contained alkoxy group may be composed of one type or two or more types.

In one embodiment, the alkoxy group is preferably a methoxy group.

In one embodiment, the alkyl group is preferably linear or branched in consideration of the ease of synthesis of the substituted PPS resin (A). The number of carbons of the alkyl group is preferably from 1 to 6, more preferably from 1 to 5, and even more preferably from 1 to 4. In one embodiment, the alkyl group may be an alkyl group having 4 carbons, an alkyl group having 3 carbons, an alkyl group having 2 carbons, or an alkyl group having 1 carbon.

In one embodiment, the alkoxy group is preferably linear or branched in consideration of the ease of synthesis of the substituted PPS resin (A). The number of carbons of the alkoxy group is preferably from 1 to 6, more preferably from 1 to 5, and even more preferably from 1 to 4. In one embodiment, the alkoxy group may be an alkoxy group having 4 carbons, an alkoxy group having 3 carbons, an alkoxy group having 2 carbons, or an alkoxy group having 1 carbon.

In consideration of the ease of synthesis of the substituted PPS resin (A), the alkyl group or the alkoxy group is preferably an alkyl group, more preferably a linear alkyl group, even more preferably a linear alkyl group having from 1 to 4 carbons, still even more preferably an ethyl group or a methyl group, and still even more preferably a methyl group.

The position of substitution with the alkyl group or the alkoxy group in General Formula (I) is not limited, and may be one or more, two or more, three or more of R₁, R₂, R₃, and R₄, or may be four.

When one alkyl group or alkoxy group is contained in General Formula (I), the substitution position thereof may be any of R₁, R₂, R₃, and R₄. The substitution position may be R₁, R₂, R₃, or R₄.

When a total of two or more alkyl groups and/or alkoxy groups are contained in General Formula (I), a combination of the substitution positions thereof is not limited. For example, when two alkyl groups and/or alkoxy groups are contained, the substitution positions may be any combination of R₁ and R₂, R₁ and R₃, R₁ and R₄, R₂ and R₃, R₂ and R₄, and R₃ and R₄. In one embodiment, the substitution positions of the alkyl groups and/or the alkoxy groups may be any two of R₁, R₃, and R₄. When the substitution positions are any two of R₁, R₃, and R₄, the combinations may be any combination of R₁ and R₃ or R₁ and R₄.

When a total of three alkyl groups and/or alkoxy groups are contained in General Formula (I), the combination may be any combination of R₁, R₂, and R₃, R₁, R₂, and R₄, R₁, R₃, and R₄, or R₂, R₃, and R₄.

In one embodiment, the substituted PPS resin (A) may have the structural unit represented by General Formula (I) in which one or more of R₁, R₂, R₃, and R₄ are aryl groups having from 1 to 10 carbons. Examples of the aryl group having from 1 to 10 carbons include a phenyl group and a naphthyl group.

When one or more alkyl groups, alkoxy groups, and/or aryl groups are contained in General Formula (I), the dielectric loss tangent of the resin composition containing the substituted PPS resin (A) tends to be low.

The structural unit represented by General Formula (I) in which one or more of R₁, R₂, R₃, and R₄ are an alkyl group or an alkoxy group encompasses the case where one or more of R₁, R₂, R₃, and R₄ which are neither an alkyl group nor an alkoxy group are an aryl group and/or an alkenyl group-containing organic group.

In the substituted PPS resin (A), the ones that are neither an R₁, R₂, R₃, and R₄ alkyl group nor an alkoxy group in Formula (I) may each independently be an alkenyl group-containing organic group. When the structural unit represented by Formula (I) has an alkenyl group-containing organic group, the structural unit represented by Formula (I) can also satisfy Formula (II) at the same time.

Here, the alkenyl group-containing organic group is not limited as long as it contains one or more alkenyl groups in the substituent, and may be an alkenylene group in which a COO group (ester) or a CO group (ketone) is interposed. The alkenyl group-containing organic group may be a linear, branched, or cyclic alkenyl group, and is preferably a linear, branched, or cyclic alkenyl group having from 2 to 10 carbons. Examples of the linear, branched, or cyclic alkenyl group having from 2 to 10 carbons include a substituent containing one or more carbon-carbon double bonds in the chain of an alkyl group having 2 or more carbons, and specific examples thereof include a vinyl group, an allyl group, a 1-propenyl group, an isopropenyl group, a 3-butenyl group, a 2-butenyl group, a 1-butenyl group, a 1,3-butadienyl group, a 4-pentenyl group, a 3-pentenyl group, a 2-pentenyl group, a 1-pentenyl group, a 1,3-pentadienyl group, a 2,4-pentadienyl group, a 1,1-dimethyl-2-propenyl group, a 1-ethyl-2-propenyl group, a 1,2-dimethyl-1-propenyl group, a 1-methyl-1-butenyl group, a 5-hexenyl group, a 4-hexenyl group, a 2-hexenyl group, a 1-hexenyl group, a 1-methyl-1-hexenyl group, a 2-methyl-2-hexenyl group, a 3-methyl-1,3-hexadienyl group, a 1-heptenyl group, a 2-octenyl group, a 3-nonenyl group, a 4-decenyl group, a cyclopropenyl group, a cyclobutenyl group, a cyclopentenyl group, a cyclohexenyl group, a cycloheptenyl group, a cyclooctenyl group, a cyclononenyl group, a cyclodecenyl group, an acrylic group (acryloyl group), a methacrylic group (methacryloyl group), an acryloyloxyalkyl group, and a methacryloyloxyalkyl group. The contained alkenyl group may be composed of one type or two or more types.

In one embodiment, the alkenyl group-containing organic group is preferably a vinyl group, an allyl group, and/or an acrylic group.

In one embodiment, the alkenyl group-containing organic group is preferably linear or branched in consideration of the ease of synthesis of the substituted PPS resin (A). The number of carbons of the alkenyl group-containing organic group is preferably from 2 to 6, more preferably from 2 to 5, even more preferably from 2 to 4, and still even more preferably from 2 to 3. In one embodiment, the alkenyl group-containing organic group may be an acrylic group or an alkenyl group having 3 carbons, or an alkenyl group having 2 carbons.

In one embodiment, when one or more of R₁, R₂, R₃, and R₄ in the structural unit represented by General Formula (I) are an alkenyl group-containing organic group, even if the substituted PPS resin (A) is composed only of the structural unit represented by General Formula (I) or contains one or more structural units other than the structural unit represented by General Formula (I), the resin composition containing the substituted PPS resin (A) tends to exhibit a thermosetting property.

Meanwhile, the unsubstituted PPS resin has good flame retardancy. Therefore, the substituted PPS resin (A) containing the structural unit represented by General Formula (I) and having the same basic skeleton as that of the unsubstituted PPS has good flame retardancy. The same applies to other structural units having a PPS skeleton whose basic skeleton is the same as that of the unsubstituted PPS, and the substituted PPS resin (A) containing the structural unit represented by General Formula (II) and/or the substituted PPS resin (A) containing the terminal structure represented by General Formula (III), which will be described below, also have good flame retardancy.

As a result, the resin composition containing the substituted PPS resin (A) has good flame retardancy.

In one embodiment, the substituted PPS resin (A) preferably contains a structural unit represented by General Formula (II): 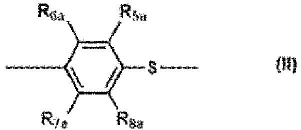 where R₅ₐ, R₆ₐ, R₇ₐ, and R₈ₐ are each independently H, an alkyl group, an alkoxy group, an aryl group, or an alkenyl group-containing organic group (preferably an alkyl group, an alkoxy group, or an alkenyl-group containing organic group), and one or more of R₅ₐ, R₆ₐ, R₇ₐ, and R₈ₐ are an alkenyl group-containing organic group. When the structural unit represented by General Formula (II) is contained, the resin composition containing the substituted PPS resin (A) tends to exhibit a thermosetting property. In addition, it is likely to exhibit good reflow resistance. The contained structural unit represented by General Formula (II) may be composed of one type or two or more types with different types and numbers of substituents.

The structural unit represented by General Formula (II) represents that one or more of substituents are an alkenyl group-containing organic group in structural units other than the structural unit located at the terminal of the resin among the structural units contained in the substituted PPS resin (A).

Examples of the alkyl group, the alkoxy group, the aryl group, and the alkenyl group-containing organic group, and the number of carbons in General Formula (II) are the same as those described for General Formula (I).

The number of carbons of the alkenyl group-containing organic group in General Formula (II) is preferably from 2 to 6, more preferably from 2 to 5, even more preferably from 2 to 4, and still even more preferably from 2 to 3, in consideration of the ease of synthesis of the substituted PPS resin. In one embodiment, the alkenyl group-containing organic group may be an alkenyl group-containing organic group having 3 carbons or an alkenyl group-containing organic group having 2 carbons, and may be, for example, an allyl group or an acrylic group, which has 3 carbons, and/or a vinyl group, which has 2 carbons.

Here, the position of substitution with the alkenyl group-containing organic group in General Formula (II) is not limited, and may be one or more, two or more, or three or more of R₅ₐ, R₆ₐ, R₇ₐ, and R₈ₐ, or may be four.

When one alkenyl group-containing organic group is contained in General Formula (II), the substitution position thereof may be any of R₅ₐ, R₆ₐ, R₇ₐ, and R₈ₐ. The substitution position may be R₅ₐ, R₆ₐ, R₇ₐ, or R₈ₐ.

When two or more alkenyl group-containing organic groups are contained in General Formula (II), a combination of the substitution positions thereof is not limited. For example, when two alkenyl group-containing organic groups are contained, the substitution positions may be any combination of R₅ₐ and R₆ₐ, R₅ₐ and R₇ₐ, R₅ₐ and R₈ₐ, R₆ₐ and R₇ₐ, R₆ₐ and R₈ₐ, or R₇ₐ and R₈ₐ. In one embodiment, the substitution position of the alkenyl group-containing organic group may be any two of R₅ₐ, R₆ₐ, and R₇ₐ, or any combination of R₅ₐ and R₇ₐ, or R₆ₐ and R₇ₐ.

For example, when three alkenyl group-containing organic groups are contained in General Formula (II), the substitution positions may be any combination of R₅ₐ, R₆ₐ, and R₇ₐ, R₅ₐ, R₆ₐ, and R₈ₐ, R₅ₐ, R₇ₐ, and R₈ₐ, or R₆ₐ, R₇ₐ, and R₈.

General Formula (II) in which one or more of R₅ₐ, R₆ₐ, R₇ₐ, and R₈ₐ are an alkenyl group-containing organic group encompasses the case where one or more of R₅ₐ, R₆ₐ, R₇ₐ, and R₈ₐ which are not an alkenyl group-containing organic group are an alkyl group or an alkoxy group. The position of substitution with the alkyl group or alkoxy group in General Formula (II) may be any of R₅ₐ, R₆ₐ, R₇ₐ, and R₈ₐ, and examples thereof and preferred examples thereof include the substitution positions exemplified in the description of General Formula (I). When the structural unit represented by Formula (II) has an alkyl group or an alkoxy group, the structural unit represented by Formula (II) can also satisfy Formula (I) at the same time.

In one embodiment, the substituted PPS resin (A) may contain a terminal structure represented by General Formula (III-a): 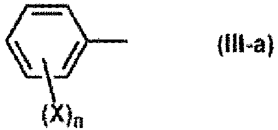 where each X is independently H, an alkyl group, an alkoxy group, an aryl group, or an alkenyl group-containing organic group (preferably an alkyl group, an alkoxy group, or an alkenyl-group containing organic group), at least one X is an alkenyl group-containing organic group, and n is an integer from 1 to 5. When the terminal structure represented by General Formula (III-a) is contained, the resin composition tends to exhibit a thermosetting property. When the terminal structure represented by General Formula (III-a) is contained, the substituted PPS resin (A) may contain the terminal structure represented by General Formula (III-a) at at least one of the terminals or at both terminals.

Even when the substituted PPS resin (A) does not have the terminal structure represented by General Formula (III-a) at any of its terminals, a resin containing one or more alkenyl group-containing organic groups in General Formula (II) can be used in combination with an additive well known to those skilled in the art for improving its curability, such as a crosslinking agent, whereby the resin composition is likely to exhibit a desired thermosetting property as a material for a wiring board.

In one embodiment, the terminal structure represented by General Formula (III-a) may be a terminal structure represented by General Formula (III-b): 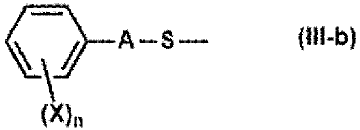
where each X is independently H, an alkyl group, an alkoxy group, an aryl group, or an alkenyl group-containing organic group (preferably an alkyl group, an alkoxy group, or an alkenyl group-containing organic group), at least one X is an alkenyl group-containing organic group, n is an integer from 1 to 5, and A is represented by General Formula (IV): 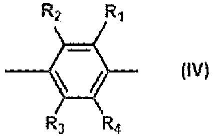
where R₁, R₂, R₃, and R₄ are each independently H, an alkyl group, an alkoxy group, an aryl group, or an alkenyl group-containing organic group (preferably an alkyl group, an alkoxy group, or an alkenyl group-containing organic group). In one embodiment, in Formula (IV), one or more of R₁, R₂, R₃, and R₄ may be an alkyl group or an alkoxy group.

In one embodiment, the terminal structure represented by General Formula (III-a) may be a terminal structure represented by General Formula (III): 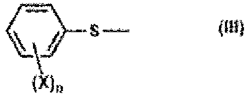 where each X is independently H, an alkyl group, an alkoxy group, an aryl group, or an alkenyl group-containing organic group (preferably an alkyl group, an alkoxy group, or an alkenyl group-containing organic group), at least one X is an alkenyl group-containing organic group, and n is an integer from 1 to 5.

The structural units represented by General Formulae (III-a), (III-b), and (III) represent that one or more of the substituents are an alkenyl group-containing organic group in the structural units located at one or both terminals of the resin among the structural units contained in the substituted PPS resin (A).

Examples of the alkyl group, the alkoxy group, the aryl group, and the alkenyl group-containing organic group in General Formulae (III-a), (III-b), and (III), and the number of carbons is the same as those described for General Formula (I).

The number of carbons of the alkenyl group-containing organic group in General Formulae (III-a), (III-b), and (III) is preferably from 2 to 6, more preferably from 2 to 5, even more preferably from 2 to 4, and still even more preferably from 2 to 3, in consideration of the ease of synthesis of the substituted PPS resin. In one embodiment, the alkenyl group-containing organic group may be an alkenyl group-containing organic group having 3 carbons or an alkenyl group-containing organic group having 2 carbons, and may be, for example, an allyl group or an acrylic group, which has 3 carbons, and/or a vinyl group, which has 2 carbons.

In General Formulae (III-a), (III-b), and (III), one or more of Xs are an alkenyl group, and the case where one or more of Xs which are not an alkenyl group-containing organic group are an alkyl group an alkoxy group, or an aryl group is also included. The position of substitution with the alkyl group, alkoxy group, or aryl group in General Formulae (III-a), (III-b), and (III) is not limited, and may be any of the five Xs.

The position of substitution with the alkenyl group-containing organic group in General Formula (III-a), (III-b), or (III) is not limited, and may be one or more of the five Xs. When one alkenyl group-containing organic group is contained in General Formula (III-a), (III-b), or (III), the substitution position thereof may be an ortho position, a meta position, or a para position with respect to S.

When a total of two or more alkenyl group-containing organic groups are contained in General Formula (III-a), (III-b), or (III), a combination of the substitution positions thereof is not limited. For example, when two alkenyl group-containing organic groups are contained, their substitution positions may be 2,3-position (or 5,6-position), 2,4-position (or 4,6-position), 2,5-position (or 3,6-position), 2,6-position, 3,4-position (or 4,5-position), or 3,5-position.

For example, when three alkenyl group-containing organic groups are contained in General Formula (III-a), (III-b), or (III), the substitution positions may be 2,3,4-position (or 4,5,6-position), 2,3,5-position (or 3,5,6-position), 2,3,6-position (or 2,5,6-position), 2,4,5-position (or 3,4,6-position), 2,4,6-position, or 3,4,5-position.

In one embodiment, the substituted PPS resin (A) has a polymer structure including two or more structural units (monomer units) capable of constituting the resin. The substituted PPS resin (A) contains a structural unit represented by General Formula (I) as at least a part of structural units thereof, and may contain one or more structural units represented by a general formula other than General Formula (I).

In the substituted PPS resin (A), the order of bonding of the structural units is not limited. For example, the structural units represented by General Formula (I) having the same combination of substituents may be adjacent to each other; the structural units represented by General Formula (II) having the same combination of substituents may be adjacent to each other; the structural units represented by General Formula (I) having different combinations of substituents may be adjacent to each other; the structural units represented by General Formula (II) having different combinations of substituents may be adjacent to each other; the structural unit represented by General Formula (I) may be adjacent to the structural unit represented by General Formula (II); or the structural unit represented by General Formula (I) or (II) may be adjacent to a structural unit other than the structural unit represented by General Formula (I) or (II). Further, the terminal structure represented by General Formula (III-a), (III-b), or (III) may be bonded to both or one of the terminals of a plurality of structural units bonded in any order.

In one embodiment, non-limiting examples of arrangements of structural units that the substituted PPS resin may contain include:
(1) a structural unit of General Formula (I) in which R₁ and R₄ are alkyl groups having from 1 to 5 carbons, and R₂ and R₃ are H;
(2) a structural unit in which R₂ and R₃ are alkyl groups having from 1 to 5 carbons, and R₁ and R₄ are H;
(3) a structural unit of General Formula (I) in which R₁ and R₃ are alkyl groups having from 1 to 5 carbons, and R₂ and R₄ are H;
(4) a structural unit of General Formula (I) in which R₂ is an alkyl group having from 1 to 5 carbons, and R₁, R₃, and R₄ are H;
(5) a structural unit of General Formula (I) in which R₁ is an alkyl group having from 1 to 5 carbons, and R₂, R₃, and R₄ are H;
(6) a structural unit of General Formula (I) in which R₂ and R₃ are alkoxy groups having from 1 to 5 carbons, and R₁ and R₄ are H;
(7) a structural unit of General Formula (I) in which R₁ and R₄ are methyl groups, and R₂ and R₃ are H;
(8) a structural unit of General Formula (I) in which R₂ and R₃ are methyl groups, and R₁ and R₄ are H;
(9) a structural unit of General Formula (I) in which R₁ and R₃ are methyl groups, and R₂, and R₄ are H;
(10) a structural unit of General Formula (I) in which R₂ is a methyl group, and R₁, R₃, and R₄ are H;
(11) a structural unit of General Formula (I) in which R₁ is an isopropyl group, and R₂, R₃, and R₄ are H; and
(12) a structural unit of General Formula (I) in which R₂ and R₃ are methoxy groups, and R₁ and R₄ are H.

In one embodiment, non-limiting examples of arrangements of structural units that the substituted PPS resin may contain include:
(13) a structural unit of General Formula (I) or (II) in which R₁ or R₄ (R₅ₐ or R₈ₐ in General Formula (II)) is an alkyl group having from 1 to 5 carbons, R₁ or R₄ (R₅ₐ or R₈ₐ in General Formula (II)) that is not an alkyl group is an alkenyl group-containing organic group having from 2 to 3 carbons, and R₂ and R₃ (R₆ₐ and R₇ₐ in General Formula (II)) are H;
(14) a structural unit of General Formula (I) or (II) in which R₂ or R₃ (R₆ₐ or R₇ₐ in General Formula (II)) is an alkyl group having from 1 to 5 carbons, R₂ or R₃ (R₆ₐ or R₇ₐ in General Formula (II)) that is not an alkyl group is an alkenyl group-containing organic group having from 2 to 3 carbons, and R₁ and R₄ (R₅ₐ and R₈ₐ in General Formula (II)) are H;
(15) a structural unit of General Formula (III-a), (III-b), or (III) in which the substitutions at the 2-position and the 6-position are alkyl groups having from 1 to 5 carbons, and each X that is not an alkyl group is H or an alkenyl group-containing organic group having from 2 to 3 carbons;
(16) a structural unit of General Formula (III-a), (III-b), or (III) in which the substitution at the 2-position or the 6-position is an alkyl group having from 1 to 5 carbons, and the substitution at the 2-position or the 6-position that is not an alkyl group is H or an alkenyl group-containing organic group having from 2 to 3 carbons;
(17) a structural unit of General Formula (III-a), (III-b), or (III) in which the substitutions at the 2-position and the 6-position are methyl groups, and each X that is not the methyl group is H or an alkenyl group-containing organic group having from 2 to 3 carbons;
(18) a structural unit of General Formula (III-a), (III-b), or (III) in which the substitution at the 3-position or the 5-position is an alkyl group having from 1 to 5 carbons, and the substitution at the 3-position or the 5-position that is not an alkyl group is H or an alkenyl group-containing organic group having from 2 to 3 carbons;
(19) a structural unit of General Formula (III-a), (III-b), or (III) in which the substitution at the 3-position or the 5-position is a methyl group, and the substitution at the 3-position or the 5-position that is not the methyl group is H or an alkenyl group-containing organic group having from 2 to 3 carbons;
(20) a structural unit of General Formula (III-a), (III-b), or (III) in which the substitution at at least one of the 2-position, the 3-position, the 4-position, the 5-position, or the 6-position is an alkenyl group-containing organic group having from 2 to 3 carbons, and each X that is not an alkenyl group-containing organic group is H or an alkyl group having from 1 to 5 carbons, and, a structural unit of General Formula (I) in which R₂ and R₃ are alkyl groups having from 1 to 5 carbons, and R₁ and R₄ are H;
(21) a structural unit of General Formula (III-a), (III-b), or (III) in which the substitution at at least one of the 2-position, the 3-position, the 4-position, the 5-position, or the 6-position is an alkenyl group-containing organic group having from 2 to 3 carbons, and each X that is not an alkenyl group-containing organic group is H or an alkyl group having from 1 to 5 carbons, and, a structural unit of General Formula (I) in which R₁ and R₄ are alkyl groups having from 1 to 5 carbons, and R₂ and R₃ are H;
(22) a structural unit of General Formula (I) or (II) in which R₁ or R₄ (R₅ₐ or R₈ₐ in General Formula (II)) is a methyl group, R₁ or R₄ (R₅ₐ or R₈ₐ in General Formula (II)) that is not a methyl group is a vinyl group, and R₂ and R₃ (R₆ₐ and R₇ₐ in General Formula (II)) are H;
(23) a structural unit of General Formula (I) or (II)in which R₂ or R₃ (R₆ₐ or R₇ₐ in General Formula (II)) is a methyl group, R₂ or R₃ (R₆ₐ or R₇ₐ in General Formula (II)) that is not a methyl group is a vinyl group, and R₁ and R₄ (R₅ₐ and R₈ₐ in General Formula (II)) are H; and
(24) a structural unit of General Formula (III-a), (III-b), or (III) in which the substitution at at least one of the 2-position, the 3-position, the 4-position, or the 5-position is a vinyl group and each X that is not a vinyl group is H or a methyl group, and, a structural unit of General Formula (I) in which R₂ or R₃ is a methyl group, and R₁ and R₄ are H.

In one embodiment, non-limiting examples of arrangements of structural units that the substituted PPS resin may contain include:
(25) a structural unit of General Formula (III-a), (III-b), or (III) in which the substitution at at least one of the 2-position or the 6-position is an alkenyl group-containing organic group having from 2 to 3 carbons, and each X that is not an alkenyl group-containing organic group is H or an alkyl group having from 1 to 5 carbons, and, a structural unit of General Formula (I) in which R₁ and R₄ are alkyl groups having from 1 to 5 carbons, and R₂ and R₃ are H; and
(26) a structural unit of General Formula (III-a), (III-b), or (III) in which at least one of the 2-position or the 6-position is a vinyl group, and each X that is not a vinyl group is H or a methyl group, and, a structural unit of General Formula (I) in which R₁ or R₄ is a methyl group, and R₂ and R₃ are H.

In one embodiment, non-limiting examples of arrangements of structural units that the substituted PPS resin may contain include:
(27) a structural unit of General Formula (III-a), (III-b), or (III) in which the substitution at at least one of the 3-position or the 5-position is an alkenyl group-containing organic group having from 2 to 3 carbons, and each X that is not an alkenyl group-containing organic group is H or an alkyl group having from 1 to 5 carbons, and, a structural unit of General Formula (I) in which R₂ and R₃ are alkyl groups having from 1 to 5 carbons, and R₁ and R₄ are H; and
(28) a structural unit of General Formula (III-a), (III-b), or (III) in which the substitution at at least one of the 3-position or the 5-position is a vinyl group, and each X that is not a vinyl group is H or a methyl group, and, a structural unit of General Formula (I) in which R₂ or R₃ is a methyl group, and R₁ and R₄ are H.

In one embodiment, the substituted PPS resin may have an alkenyl group-containing organic group at any substitution position in General Formula (I), General Formula (II), and/or General Formula (III-a), (III-b), or (III), and the alkenyl group-containing organic group may have from 2 to 3 carbons, or may be a vinyl group.

In one embodiment, the substituted PPS resin may be one or more selected from a 2,6-dimethyl PPS resin, a 3,5-dimethyl PPS resin, a 2,5-dimethyl PPS resin, a 3-monomethyl PPS resin, and a 2-isopropyl PPS resin, which may have one or more alkenyl group-containing organic groups having from 2 to 3 carbons (preferably have one or more alkenyl group-containing organic groups having from 2 to 3 carbons). In one embodiment, the substituted PPS resin may be one or more selected from a 2,6-dimethyl PPS resin, a 3,5-dimethyl PPS resin, a 2,5-dimethyl PPS resin, a 3-monomethyl PPS resin, and a 2-isopropyl PPS resin, which may have one or more vinyl groups.

In one embodiment, the content of the structural unit containing an alkyl group and/or an alkoxy group in the substituted PPS resin (A) is preferably 30 mol% or more. When the content is 30 mol% or more, it may be 40 mol% or more, 50 mol% or more, 60 mol% or more, 70 mol% or more, 80 mol% or more, 90 mol% or more, or 100 mol%.

The content of the structural unit containing an alkyl group and/or an alkoxy group in the substituted PPS resin (A) can be calculated from the amount of the monomer charged. In addition, the measurement can be performed by ¹H-NMR analysis.

When the content of the structural unit containing an alkyl group and/or an alkoxy group in the substituted PPS resin is 30 mol% or more, the dielectric loss tangent of the resin composition containing the substituted PPS resin (A) is likely to be low.

In one embodiment, the content of the structural unit having an alkenyl group-containing organic group in the substituted PPS resin (A) is preferably one or more structural units (e.g., two or more structural units) and 20 mol% or less, more preferably from 0.1 to 20 mol% (e.g., from 1 to 20 mol%), further preferably from 0.2 to 18 mol% (e.g., from 1 to 18 mol%), still further preferably from 0.5 to 15 mol% (e.g., from 2 to 10 mol%), and particularly preferably from 0.8 to 10 mol% (e.g., from 2 to 7 mol%).

In one embodiment, only one structural unit may have an alkenyl group-containing organic group. Even when it is a resin in which only one structural unit of the substituted PPS resin (A) has an alkenyl group-containing organic group, the resin composition easily exhibits a thermosetting property.

In one embodiment, the content of the structural unit having an alkenyl group-containing organic group in the substituted PPS resin (A) may be in a range obtained by combining any of the upper limits and any of the lower limits described above.

The content of the structural unit having an alkenyl group-containing organic group in the substituted PPS resin (A) can be calculated from the preparation amount of the monomer. In addition, the measurement can be performed by ¹H-NMR analysis.

The glass transition temperature (Tg) of the substituted PPS resin (A) is preferably 250°C or lower, and more preferably 245°C or lower. When the glass transition temperature (Tg) of the substituted PPS resin (A) is 250°C or lower, the glass transition temperature (Tg) of the resin composition blended with the radical polymerizable compound (B) and/or the styrene-based (co)polymer (D) described later is likely to decrease, and the resin composition is likely to be cured at a low temperature (240°C or lower).

In one embodiment, the glass transition temperature (Tg) of the substituted PPS resin (A) is preferably from 25 to 250°C (e.g., from 90 to 250°C), and may be from 30 to 245°C (e.g., from 100 to 245°C).

The glass transition temperature can be measured by differential scanning calorimetry (DSC) in accordance with JIS standard (JIS K 7121: Method for measuring transition temperature of plastics) under a temperature increase condition at 20°C/min from room temperature.

The weight-average molecular weight (Mw) of the substituted PPS resin (A) is preferably from 1000 to 33000, and may be from 3000 to 33000 (e.g., from 10000 to 33000, from 15000 to 33000, from 20000 to 30000, or from 23000 to 30000), may be from 5000 to 28000 (e.g., from 15000 to 28000), or may be from 6000 to 27000 (e.g., from 10000 to 27000). When the weight-average molecular weight (Mw) of the substituted PPS resin (A) is 1000 or more, the dielectric loss tangent tends to be low. When the weight-average molecular weight (Mw) of the substituted PPS resin (A) is 33000 or less, the glass transition temperature tends to be a desired temperature.

The weight-average molecular weight (Mw) is a value in terms of standard polystyrene determined by GPC measurement using a tetrahydrofuran solvent.

The method for synthesizing the substituted PPS resin (A) is not limited. The substituted PPS resin can be produced by a known method in the art, for example, a method of mixing one or more monomer materials required for producing a desired substituted PPS resin (A) and polymerizing the mixture under appropriate conditions to form a polymer structure, or a method of polymerizing a pre-prepared oligomer to form a polymer structure. In the case of containing a structural unit having an alkenyl group-containing organic group, it is possible to synthesize a substituted PPS resin (A) containing a structural unit having an alkyl group, and then deprotonate some of the alkyl groups to produce a substituted PPS resin (A) substituted with an alkenyl group-containing organic group.

### Filler (B)

The resin composition preferably contains a filler (B). By containing the filler (B), the resin composition containing the substituted PPS resin (A) tends to have a low thermal expansion coefficient. In other words, the filler (B) can act as a thermal expansion coefficient lowering agent for the resin composition containing the substituted PPS resin (A).

The type of the filler is not particularly limited, but is preferably an inorganic filler. Examples of the inorganic filler include silica, titanium oxide, apatite, glass beads, calcium carbonate, carbon black, and the like (mainly spherical fillers), mica, talc, kaolin, calcined kaolin, glass flakes, and the like (mainly plate-like fillers), glass fibers, potassium titanate fibers, gypsum fibers, brass fibers, stainless steel fibers, steel fibers, ceramic fibers, boron whisker fibers, and the like (mainly fibrous fillers). The shape of the filler may be either spherical, plate-like, or fibrous. When the filler is silica, it is not limited by its preparation method or the presence or absence of a pore structure, and may be fused crushed silica, fused spherical silica, crystalline silica, amorphous silica, secondary agglomerated silica, fine powder silica, hollow silica, porous silica, or the like.

The filler is preferably a spherical inorganic filler, and more preferably a spherical filler of silica, alumina (aluminum hydroxide), or boron nitride. For example, when heat dissipation is desired, a spherical filler of boron nitride may be selected.

The size of the filler can be appropriately determined by those skilled in the art, and the length (average value) of the longest axis or side of the filler may be, for example, 10 µm or less, 5 µm or less, 1 µm or less, or 0.5 µm or less, but is preferably from 0.1 µm to 8 µm, more preferably from 0.2 µm to 5 µm, and still more preferably from 0.3 µm to 3 µm. In the case of a spherical filler, the average particle size may be, for example, 10 µm or less, 5 µm or less, 1 µm or less, or 0.5 µm or less, but is preferably from 0.1 µm to 8 µm, more preferably from 0.2 µm to 5 µm, and still more preferably from 0.3 µm to 3 µm. When the length (average value) of the longest axis or side of the filler or the average particle size of the spherical filler is from 0.1 µm to 8 µm, the resin composition containing the substituted PPS resin (A) is likely to maintain a desired low dielectric loss tangent. Furthermore, even when the resin composition containing the substituted PPS resin (A) is used for a printed wiring board having a narrow wiring pitch (e.g., from 20 µm to 80 µm), migration failure is less likely to occur because the length of the longest axis or side of the filler or the average particle size of the spherical filler is from 0.1 µm to 8 µm.

The filler may be surface-treated by a known method, and examples of the surface treatment agent include silane-based, titanate-based, and aluminate-based coupling agents. From the viewpoint of keeping low the dielectric loss tangent of the resin composition containing the substituted PPS resin (A), it is preferably surface-treated with a silane-based surface treatment agent. Examples of the silane-based surface treatment agent include a vinyl silane treatment agent, an amino silane treatment agent, and a phenyl silane treatment agent. For example, in consideration of the adhesiveness to the components other than the filler in the resin composition, the surface treatment agent is more preferably a vinyl silane treatment agent.

For the filler, a single type may be used alone, or two or more types may be used in combination.

### Glass Cloth (C)

The resin composition is preferably impregnated into the glass cloth (C). In one embodiment, the resin composition preferably contains the substituted polyphenylene sulfide resin (A) and the filler (B), and is impregnated into the glass cloth (C).

By being impregnated into the glass cloth (C), the resin composition containing the substituted PPS resin (A) tends to have a low thermal expansion coefficient. In other words, the glass cloth (C) can act as a thermal expansion coefficient lowering agent for the resin composition containing the substituted PPS resin (A).

By containing the filler (B) and being impregnated into the glass cloth (C), the resin composition containing the substituted PPS resin (A) is more likely to have a lower thermal expansion coefficient than that when containing only the filler (B), or when being simply impregnated into the glass cloth (C).

The type of the glass cloth (C) is not particularly limited, and dielectric characteristics, glass fiber diameter, thickness and density, glass material, type of surface treatment agent, and the like can be appropriately selected according to the purpose. However, in consideration of the effects required for the resin composition containing the substituted PPS resin (A), a glass cloth having a low dielectric loss tangent and/or a low dielectric property is preferable. Commercially available glass cloth may be used. Examples of such glass cloth include glass cloth using E-glass and glass cloth using NE-glass. Examples of glass cloth using NE-glass include NE-2116 (manufactured by Nitto Boseki Co., Ltd.) and NE-1078 (manufactured by Nitto Boseki Co., Ltd.). The glass cloth using NE-glass has a low dielectric property and a low dielectric loss tangent, and is preferable when the resin composition containing the substituted PPS resin (A) is used for a wiring board.

For the glass cloth, a single type may be used alone, or two or more types may be used in combination.

### Content of Components A to C

Hereinafter, the substituted PPS resin (A), the filler (B), and the glass cloth (C) are also collectively referred to as components (A) to (C).

The content of the substituted PPS resin (A) in the resin composition is preferably from 30 to 80 parts by mass, more preferably from 40 to 70 parts by mass, and still more preferably from 50 to 70 parts by mass, relative to 100 parts by mass of the total of the components (A) and (B). When the content of the substituted PPS resin (A) in the resin composition is from 30 to 80 parts by mass relative to 100 parts by mass of the total of the components (A) and (B), the effect of the low dielectric loss tangent of the substituted PPS resin (A) is easily exhibited, and the effect of lowering the thermal expansion coefficient by blending the filler (B) and/or the glass cloth (C) is easily achieved, in the cured product of the resin composition.

In one embodiment, the content of the substituted PPS resin (A) in the resin composition may be 51 parts by mass, 52 parts by mass, 55 parts by mass, 56 parts by mass, 61 parts by mass, 66 parts by mass, or 67 parts by mass relative to 100 parts by mass of the total of the components (A) and (B), or may be in a range obtained by combining these values, or may be in a range obtained by using these values as the upper limit value or the lower limit value of the above range.

The content of the substituted PPS resin (A) in the resin composition is preferably 25 mass% or more based on the total resin composition (excluding the solvent) (100 mass%), from the viewpoint that the resin composition is likely to have a desired dielectric loss tangent. When the content is 25 mass% or more, the content may be 30 mass% or more, 35 mass% or more, 40 mass% or more, 45 mass% or more, or 50 mass% or more.

In one embodiment, the resin composition may contain additional resin components such as an unsubstituted PPS resin and an unsubstituted or substituted PPE as resin components other than the substituted PPS resin (A), but from the viewpoint of easily having a low dielectric loss tangent, the total content of the substituted PPS resin (A) is preferably 50 mass% or more, more preferably 60 mass% or more, further preferably 70 mass% or more, still further preferably 80 mass% or more, and particularly preferably 90 mass% or more, relative to all the resin components (100 mass%) contained in the resin composition. In one embodiment, the content of the substituted PPS resin (A) in the thermoplastic resin contained in the resin composition may be 95 mass% or more, 98 mass% or more, or 100 mass%.

The content of the filler (B) in the resin composition is preferably from 20 parts by mass to 70 parts by mass, more preferably from 30 parts by mass to 60 parts by mass, and still more preferably from 30 parts by mass to 50 parts by mass, relative to 100 parts by mass of the total of the components (A) and (B). When the content is from 20 parts by mass to 70 parts by mass, the content may be 20 parts by mass, 33 parts by mass, 38 parts by mass, 44 parts by mass, 48 parts by mass, or 70 parts by mass, or may be in a range obtained by using these values as the upper limit value or the lower limit value of the above range.

When the content of the filler (B) in the resin composition is 20 parts by mass to 70 parts by mass relative to 100 parts by mass of the substituted polyphenylene sulfide resin (A), the effect of the low dielectric loss tangent of the substituted PPS resin (A) is easily exhibited, and the effect of lowering the thermal expansion coefficient of the filler (B) is easily achieved.

When the resin composition is impregnated into the glass cloth (C), the content of the glass cloth (C) is from 10 mass% to 60 mass%, preferably from 20 mass% to 50 mass%, and may be 22 mass%, relative to 100 mass% of the resin composition (excluding the solvent) containing the substituted polyphenylene sulfide resin (A). The resin composition containing the substituted polyphenylene sulfide resin (A) may contain a "styrene-based (co)polymer (D)", a "radical polymerizable compound (E)", and/or an "organic peroxide (F)" described below.

When the content of the glass cloth (C) in the resin composition is from 20 mass% to 50 mass% relative to 100 mass% of the resin composition (excluding the solvent) containing the substituted polyphenylene sulfide resin (A), the thermal expansion coefficient is likely to be low.

### Styrene-Based (Co)Polymer (D)

The resin composition preferably contains a styrene-based (co)polymer (D).

In one embodiment, the resin composition may contain the substituted polyphenylene sulfide resin (A) and the styrene-based (co)polymer (D), and may also contain the filler (B) and/or be impregnated into the glass cloth (C).

In one embodiment, the resin composition may contain the substituted polyphenylene sulfide resin (A), the styrene-based (co)polymer (D), and a radical polymerizable compound (E), and may also contain the filler (B) and/or be impregnated into the glass cloth (C).

In one embodiment, the resin composition may contain the substituted polyphenylene sulfide resin (A), the filler (B), the styrene-based (co)polymer (D), and the radical polymerizable compound (E), and may also be impregnated into the glass cloth (C).

In the present disclosure, the term "styrene-based (co)polymer (D)" may include a homopolymer of a styrene-based monomer and a copolymer of a styrene-based monomer and another vinyl-based monomer. The styrene-based (co)polymer (D) can also be referred to as a styrene-based homopolymer or a styrene-based copolymer. By containing the styrene-based (co)polymer (D), the resin composition containing the substituted PPS resin (A) tends to be curable at a low temperature while maintaining the low dielectric loss tangent property of the substituted PPS resin (A). In other words, the styrene-based (co)polymer (D) can act as a curing temperature lowering agent for the resin composition containing the substituted PPS resin (A). In addition, the toughness of the resin composition is likely to be improved. As a result, even when the film-like cured product is deformed, cracks are less likely to occur. The term "low temperature" means a temperature lower than the temperature in the case of curing the substituted PPS resin (A) alone, and examples thereof include a temperature of 240°C or lower. The resin composition cured at 240°C or lower does not require a special curing device, and can be cured using a general heating and drying device.

In one embodiment, the resin composition preferably contains the substituted polyphenylene sulfide resin (A) and the styrene-based (co)polymer (D). By containing the substituted polyphenylene sulfide resin (A) and the styrene-based (co)polymer (D), a resin composition is likely to have a low dielectric loss tangent, is more likely to be cured at a low temperature, and is likely to have excellent toughness.

In one embodiment, the resin composition preferably contains the substituted polyphenylene sulfide resin (A), the radical polymerizable compound (E), and the styrene-based (co)polymer (D). By containing the substituted polyphenylene sulfide resin (A), the radical polymerizable compound (E), and the styrene-based (co)polymer (D), the resin composition is likely to have a low dielectric loss tangent, is more likely to be cured at a low temperature, and is likely to have excellent toughness.

Examples of the styrene-based (co)polymer (D) include general-purpose polystyrene (GPPS), high-impact polystyrene (HIPS), and styrene-based thermoplastic elastomers. The styrene-based (co)polymer (D) may be composed of one type or two or more types.

Examples of the styrene-based thermoplastic elastomer include a copolymer containing a styrene unit and a conjugated diene unit. The styrene unit is a structural unit derived from a styrene monomer. The styrene monomer may be selected from at least one type selected the group consisting of styrene or styrene having a substituent. Examples of the substituent include alkyl groups, such as a methyl group. The conjugated diene unit is a structural unit derived from a conjugated diene monomer. Examples of the conjugated diene unit include an ethylene unit, a propylene unit, a butylene unit, an α-olefin unit, a butadiene unit, a hydrogenated butadiene unit, an isoprene unit, and a hydrogenated isoprene unit. For the olefin unit, a hydrogenated isoprene unit or a hydrogenated butadiene unit is particularly preferably contained. The contained olefin unit may be composed of one type or two or more types.

Specific examples of the styrene-based thermoplastic elastomer include unhydrogenated styrene-conjugated diene copolymers such as styrene-butadiene copolymers, styrene-butadiene-styrene copolymers (SBS), styrene-butadiene-butylene-styrene copolymers, styrene-isoprene copolymers, styrene-isoprene-styrene copolymers (SIS), and styrene-ethylene-isoprene-styrene copolymers; and hydrogenated styrene-conjugated diene copolymers such as styrene-ethylene/propylene-styrene copolymers (SEPS: hydrogenated products of styrene-isoprene-styrene copolymers), styrene-ethylene/butylene-styrene copolymers (SEBS: hydrogenated products of styrene-butadiene copolymers), and hydrogenated methylstyrene (ethylene/ethylene propylene) methylstyrene copolymers.

In one embodiment, the styrene-based (co)polymer (D) preferably contains a styrene-based thermoplastic elastomer. When the styrene-based thermoplastic elastomer is contained, a lower dielectric constant is easily realized, and more excellent toughness is easily exhibited. In one embodiment, the styrene-based (co)polymer (D) preferably contains a hydrogenated product of a styrene-based copolymer.

The content of the styrene unit contained in the styrene-based (co)polymer (D) (hereinafter, also referred to as "styrene ratio") is preferably from 20 to 100 mass%, more preferably from 20 to 90 mass%, still more preferably from 25 to 80 mass%, and particularly preferably from 30 to 70 mass% based on all the monomer units (100 mass%). In one embodiment, the styrene ratio may be from 45 to 100 mass%, or from 50 to 100 mass%. In one embodiment, the styrene ratio may be 30 mass%, 49 mass%, 62 mass%, 67 mass%, 68 mass%, or 100 mass%, or may be in a range obtained by combining these values, or may be in a range obtained by using these values as the upper limit value or the lower limit value of the above range. When the styrene ratio is 20 mass% or more, the resin composition is likely to have a low dielectric loss tangent. When the styrene ratio is 90 mass% or less, the resin composition can easily achieve a lower dielectric constant.

The styrene ratio can be calculated from the amount of the raw material monomer used, or can be measured by analyzing the resin composition by ¹H-NMR.

The weight-average molecular weight (Mw) of the styrene-based (co)polymer (D) may be, for example, 150000 or less, or 100000 or less. The method for measuring the weight-average molecular weight (Mw) is as described above.

In one embodiment, the content ratio of the substituted PPS resin (A) to the styrene-based (co)polymer (D) is preferably from 1.5 to 10.0, more preferably from 2.0 to 9.5, and still more preferably from 2.3 to 9.0, as a value (A/D) of a ratio of (content of substituted PPS resin (A))/(content of styrene-based (co)polymer (D)). In one embodiment, the value of the ratio (A/D) may be 1.7, 2.3, 2.4, 3.0, 4.0, 4.7, or 9.0, may be in a range defined by using these values as the upper limit value or the lower limit value of the numerical range, or may be in a range obtained by combining these.

The content of the styrene-based (co)polymer (D) is preferably from 10 parts by mass to 100 parts by mass, more preferably from 20 parts by mass to 80 parts by mass, and still more preferably from 30 parts by mass to 70 parts by mass, relative to 100 parts by mass of the substituted polyphenylene sulfide resin (A). When the content is from 30 parts by mass to 70 parts by mass, the content may be 30 parts by mass, 33 parts by mass, 60 parts by mass, or 70 parts by mass. When the content is from 10 parts by mass to 100 parts by mass, the curing temperature of the resin composition containing the substituted PPS resin (A) tends to be low. In addition, the effect of the low dielectric loss tangent of the substituted PPS resin (A) is easily exhibited, and the effect of lowering the thermal expansion coefficient by blending the filler (B) and/or the glass cloth (C) is easily achieved.

### Radical Polymerizable Compound (E)

The resin composition preferably contains the radical polymerizable compound (E). In one embodiment, the resin composition may contain the substituted polyphenylene sulfide resin (A) and the radical polymerizable compound (E), and may also contain the filler (B) and/or be impregnated into the glass cloth (C).

In one embodiment, the resin composition may contain the substituted polyphenylene sulfide resin (A), the filler (B), and the radical polymerizable compound (E), and may also be impregnated into the glass cloth (C).

By containing the radical polymerizable compound (E), the resin composition containing the substituted PPS resin (A) tends to be curable at a low temperature while maintaining the low dielectric loss tangent property of the substituted PPS resin (A). In other words, the radical polymerizable compound (E) can act as a curing temperature lowering agent for the resin composition containing the substituted PPS resin (A). The term "low temperature" means a temperature lower than the temperature in the case of curing the substituted PPS resin (A) alone, and examples thereof include a temperature of 240°C or lower. The resin composition cured at 240°C or lower does not require a special curing device, and can be cured using a general heating and drying device.

The radical polymerizable compound (E) is a compound that is polymerizable by a thermal radical polymerization reaction and has a radical polymerizable unsaturated bond. Note that the substituted PPS resin (A) is also a compound polymerizable by a thermal radical polymerization reaction, but the term "radical polymerizable compound (E)" in the present disclosure is distinguished from the substituted PPS resin (A). In other words, the radical polymerizable compound (E) does not include the substituted PPS resin (A). In one embodiment, the radical polymerizable compound (E) does not have a constituent structure represented by General Formula (I). In another embodiment, the radical polymerizable compound (E) does not have a PPS skeleton.

Examples of the radical polymerizable compound (E) include compounds having at least one selected from the group consisting of a carbon-carbon unsaturated double bond and a maleimide group.

Examples of the carbon-carbon unsaturated double bond include double bonds contained in an allyl group, a vinyl group, an acrylate group, and a methacrylate group. Examples of the radical polymerizable compound (B) having a carbon-carbon unsaturated double bond include monofunctional compounds such as 1-octadecene, stearyl methacrylate, dicyclopentanyl methacrylate, and isobornyl methacrylate; and polyfunctional compounds such as divinylbenzene, 1,2-bis(4-vinylphenyl)ethane (BVPE), dicyclopentadiene, methylcyclopentadiene dimer, trivinylcyclohexane, triallyl isocyanurate (TAIC), dicyclopentadiene dimethanol dimethacrylate, nonanediol dimethacrylate, 1,3-diisopropenyl benzene, and trimethylolpropane triacrylate. An example of the commercially available radical polymerizable compound (B) is DD-1 manufactured by SHIKOKU CHEMICALS CORPORATION.

Examples of the radical polymerizable compound (E) having a maleimide group include phenyl maleimide, cyclohexyl maleimide, 4,4'-diphenylmethane bismaleimide, m-phenylene bismaleimide, bisphenol A diphenyl ether bismaleimide, 3,3'-dimethyl-5,5'-diethyl-4,4'-diphenylmethane bismaleimide, 4-methyl-1,3-phenylene bismaleimide, and 1,6-bismaleimide-(2,2,4-trimethyl)hexane.

The radical polymerizable compound (E) preferably contains one or more selected from the compounds exemplified above. For the radical polymerizable compound (E), a single type may be used alone or two or more types may be used in combination.

The molecular weight (weight-average molecular weight) of the radical polymerizable compound (E) is preferably from 100 to 3000, more preferably from 130 to 2000, and still more preferably from 150 to 1000, and it may be from 180 to 500. When the molecular weight of the radical polymerizable compound (B) is from 100 to 3000, the crosslinking density increases, and the glass transition temperature is less likely to decrease. The molecular weight can be measured or calculated using a known method. When the molecular weight is the weight-average molecular weight, it is a value in terms of standard polystyrene determined by GPC measurement using a tetrahydrofuran solvent.

In one embodiment, the content ratio of the substituted PPS resin (A) to the radical polymerizable compound (E) is preferably from 1.2 to 6.0, more preferably from 1.3 to 5.5, and still more preferably from 1.5 to 4.7, as a value (A/E) of a ratio of (content of substituted PPS resin (A))/(content of radical polymerizable compound (E)). In one embodiment, the value of the ratio (A/E) may be 1.5, 1.9, 4.0, or 4.7, or may be in a range defined by using these values as the upper limit value or the lower limit value of the numerical range.

The content of the radical polymerizable compound (E) is preferably from 20 parts by mass to 100 parts by mass, and more preferably from 25 parts by mass to 55 parts by mass, relative to 100 parts by mass of the substituted polyphenylene sulfide resin (A). When the content is from 20 parts by mass to 100 parts by mass, the effect of the low dielectric loss tangent of the substituted PPS resin (A) is easily exhibited, and the effect of lowering the thermal expansion coefficient by blending the filler (B) and/or the glass cloth is easily achieved. In addition, the curing temperature of the resin composition containing the substituted PPS resin (A) tends to be low.

In a case where the resin composition contains the radical polymerizable compound (E) and the styrene-based (co)polymer (D), the content ratio of the radical polymerizable compound (E) to the styrene-based (co)polymer (D) is preferably from 0.8 to 2.0, more preferably from 0.9 to 1.8, and still more preferably from 1.0 to 1.6, as a value (E/D) of a ratio of (content of radical polymerizable compound (E))/(content of styrene-based (co)polymer (D)). When the ratio is from 1.0 to 1.6, it may be 1.6 or 1.7. When the value of the ratio of (content of E)/(content of D) is from 0.8 to 2.0, the resin composition tends to have a low dielectric loss tangent and tends to be cured at a low temperature. In addition, toughness is likely to be improved.

### Organic Peroxide (F)

The resin composition preferably contains an organic peroxide (F). By containing the organic peroxide (F), the composition is easily cured at a low temperature.

Examples of the organic peroxide (F) include 1,3-bis (t-butylperoxyisopropyl)benzene, dicumyl peroxide, 2,5-dimethyl-2,5-di(t-butylperoxy)hexane, di-t-butyl peroxide, 2,5-dimethyl-2,5-di(t-butylperoxy)-3-hexyne, benzoyl peroxide, 3,3',5,5'-tetramethyl-1,4-diphenoquinone, chloranil, 2,4,6-tri-t-butylphenoxyl, t-butylperoxyisopropyl monocarbonate, and azobisisobutyronitrile. The contained organic peroxide (F) may be composed of one type or two or more types.

The content of the organic peroxide (F) is preferably from 1 part by mass to 10 parts by mass, more preferably from 1 part by mass to 5 parts by mass, and even more preferably from 1 part by mass to 3 parts by mass, relative to 100 parts by mass of the substituted polyphenylene sulfide resin (A). When the content is from 1 part by mass to 3 parts by mass, the content may be 1.6 parts by mass. When the content is 1 part by mass or more, the curing temperature of the resin composition containing the substituted PPS resin (A) tends to be low. When the content is 10 parts by mass or less, the effect of the low dielectric loss tangent of the substituted PPS resin (A) is easily exhibited, and the effect of lowering the thermal expansion coefficient by blending the filler (B) and/or the glass cloth is easily achieved.

### Solvent

The resin composition may contain a solvent. When the resin composition contains a solvent, the resin composition can be used as a varnish. In general, the varnish is preferably a polymer solution in which a resin component is dissolved in an organic solvent. In one embodiment, the polymer may be at least partially dissolved at a liquid temperature of 25°C, but preferably, the polymer is completely dissolved.

The organic solvent is not limited and can be selected by those skilled in the art from organic solvents well known in the art. Examples thereof include acetone, ethyl acetate, cyclohexane, heptane, tetrahydrofuran, dimethylformamide, dimethylacetamide, dimethyl sulfoxide, ethylene glycol, cellosolve-based solvents, carbitol-based solvents, anisole, N-methylpyrrolidone, propylene glycol monomethyl ether, methyl ether acetate, toluene, cyclohexanone, methyl ethyl ketone, and methyl isobutyl ketone. One type selected from these organic solvents may be used, or two or more types selected therefrom may be used in combination.

The lower limit of the content of the solute (component other than the solvent) in the polymer solution is not limited as long as a handleable and adequately producible polymer solution is prepared. For example, the lower limit may be from 5 to 50 mass%, from 7 to 45 mass%, from 10 to 40 mass%, or from 10 to 35 mass% relative to 100 mass% of the polymer solution.

### Other Additives

The resin composition may further contain, for example, an additive such as an inorganic filler, a silane coupling agent, an antifoaming agent, an antioxidant, a heat stabilizer, an antistatic agent, an ultraviolet absorber, a dye or a pigment, and a lubricant, as necessary.

Examples of the inorganic filler include silica, alumina, talc, aluminum hydroxide, magnesium hydroxide, titanium oxide, mica, aluminum borate, barium sulfate, boron nitride, forsterite, zinc oxide, magnesium oxide, and calcium carbonate. The inorganic filler may be surface-treated. When the inorganic filler is contained, the content thereof is preferably from 30 to 80 parts by mass, more preferably from 40 to 70 parts by mass, relative to 100 parts by mass of the total of the substituted polyphenylene sulfide resin (A), the radical polymerizable compound (B), and the styrene-based (co)polymer (D).

The resin composition may contain a flame retardant, but since the substituted PPS resin (A) has good flame retardancy as described above, the content of the flame retardant (e.g., a flame retardant containing bromine or phosphorus) in the resin composition may be 10 mass% or less, less than 8 mass%, 5 mass% or less, 3 mass% or less, or 1 mass% or less. In one embodiment, the resin composition need not contain a flame retardant.

### Resin Composition

The method for producing the resin composition is not limited, and the production can be carried out by equipment and a method generally used in preparing a resin composition. In general, the resin composition containing the substituted PPS resin (A) is often prepared as a polymer solution (resin varnish) dissolved in an organic solvent.

The substituted PPS resin (A), the radical polymerizable compound (B) and/or the styrene-based (co)polymer (D), and additives soluble in an organic solvent among the additives used as necessary may be added to an organic solvent and mixed, for example, by stirring with a stirrer, for preparing such a resin varnish. In this case, heating may be performed as necessary. Thereafter, a component insoluble in the organic solvent (e.g., an inorganic filler) may be appropriately added, and the mixture may be dispersed until a predetermined dispersion state is achieved using a ball mill, a bead mill, a planetary mixer, a roll mill, or the like, thereby preparing a resin varnish. Examples of the organic solvent are the same as those described in the section on "Varnish" below.

In one embodiment, the resin composition has a dielectric loss tangent at 10 GHz of preferably 0.002 or less, more preferably less than 0.002, and even more preferably 0.0018 or less. The lower the dielectric loss tangent, the easier it is to suppress the transmission loss when the resin composition is used as a material for a wiring board. When the dielectric loss tangent at 10 GHz is 0.002 or less, the transmission loss at 10 GHz is easily suppressed when the resin composition is used as a material for a wiring board.

In one embodiment, the resin composition has a dielectric loss tangent at 40 GHz of preferably 0.003 or less, and more preferably 0.0025 or less. When the dielectric loss tangent at 40 GHz is 0.003 or less, the transmission loss at 40 GHz is easily suppressed when the resin composition is used as a material for a wiring board.

In one embodiment, the resin composition has a dielectric constant at 10 GHz of preferably less than 3.00, more preferably 2.80 or less, and even more preferably 2.60 or less. The lower the dielectric constant, the easier it is to suppress the transmission loss when the resin composition is used as a material for a wiring board. When the dielectric constant at 10 GHz is less than 3.00, the transmission loss at 10 GHz is easily suppressed when the resin composition is used as a material for a wiring board.

In one embodiment, the resin composition has a dielectric constant at 40 GHz of preferably less than 3.00, more preferably 2.90 or less, and even more preferably 2.85 or less. When the dielectric constant at 40 GHz is less than 3.00, the transmission loss at 40 GHz is easily suppressed when the resin composition is used as a material for a wiring board.

The dielectric loss tangent and the dielectric constant are measured using a sheet of the resin composition at a predetermined frequency using a vector network analyzer and a split-cylinder resonator.

In one embodiment, the glass transition temperature (Tg) of the resin composition is preferably 240°C or less, more preferably less than 240°C, further more preferably 230°C or less, still more preferably 220°C or less, and even more preferably 200°C or less. When the glass transition temperature (Tg) of the resin composition is 240°C or less, the resin composition is easily cured at a low temperature (240°C or less).

In one embodiment, the glass transition temperature (Tg) of the resin composition is preferably from 25 to 240°C (e.g., from 90 to 240°C), may be from 30 to 230°C (e.g., from 100 to 230°C), may be from 40 to 220°C (e.g., from 120 to 220°C), may be from 50 to 210°C (e.g., from 150 to 210°C), and may be from 60 to 200°C (e.g., from 170 to 200°C). The method for measuring the glass transition temperature is as described above.

In one embodiment, the resin composition has a thermal expansion coefficient measured under the following conditions of preferably 60 ppm/K or less, and more preferably 30 ppm/K or less. When the resin composition is used as a material for a wiring board, a laminate produced by laminating with other lamination materials such as metal foil is less likely to warp because the thermal expansion coefficient is 60 ppm/K or less.

The thermal expansion coefficient (α1 (in a region lower than Tg)) is determined from a strain-temperature curve obtained under the following conditions for a cured product of the resin composition.
Measurement equipment: TMA SS7100/Hitachi High-Tech Science Corporation
Measurement Mode: Tensile
Atmosphere: N₂
Temperature range: 1st heat/0°C to 250°C
2nd heat/0°C to 250°C
Wait for 20 minutes at the start temperature
Temperature increase rate: 5°C/min
Measurement load: 20 mN

### Second Embodiment: Article for Wiring Board

The article for a wiring board according to the present embodiment contains the above-described resin composition. Since the resin composition described above is contained, the wiring board formed using the article for a wiring board has a low dielectric loss tangent. Examples of the article for a wiring board include an interlayer insulating film, a prepreg, a metal-clad laminate, and a substrate.

### Interlayer Insulating Film

Examples of the interlayer insulating film include interlayer insulating films used in printed wiring boards and the like. The interlayer insulating film can also be used as a material for a multilayer printed wiring board.

The interlayer insulating film can be produced, for example, by applying a varnish containing the resin composition and an organic solvent to another material and volatilizing the solvent. This can also be used to prepare a laminate structure for a multilayer printed circuit board.

### Prepreg

Examples of the prepreg include a prepreg produced by impregnating a base material with a varnish containing a resin composition and an organic solvent, followed by drying. The base material used for the prepreg is not limited and can be selected by those skilled in the art from materials well known in the art, and examples thereof include natural fiber base materials, organic synthetic fiber base materials, and inorganic fiber base materials.

### Metal-Clad Laminate

An example of the metal-clad laminate is a metal-clad laminate containing the prepreg. Such a metal-clad laminate can be produced, for example, by stacking a plurality of prepregs, stacking a metal foil on one surface or both surfaces of the stacked product, followed by press-molding under heat and pressure. Examples of the metal foil include a copper foil, an aluminum foil, a tin foil, a gold foil, a silver foil, a platinum foil, and a nickel foil. The metal foil can be selected by those skilled in the art based on the properties and applications required of the metal-clad laminate.

### Substrate

The substrate is a pedestal used together with a semiconductor chip such as a CPU or a memory for protecting the semiconductor chip and mounting it on a printed circuit board (PCB). For example, the substrate may be a board portion in FC-BGA (Flip Chip-Ball Grid Array), FC-CSP (Flip Chip Chip Scale Package), or the like. The substrate can be produced by, for example, molding the resin composition into a plate shape using a known molding apparatus and method.

### Third Embodiment: Wiring Board

The wiring board according to the present embodiment contains the resin composition described above. Since the wiring board contains the resin composition described above, it has a low dielectric loss tangent.

The wiring board is a board to be attached with an electronic component such as a semiconductor and to be provided with wiring, and is not limited by its structure and/or application. In the present specification, the wiring board includes a portion of a printed wiring board other than an electronic component such as a semiconductor, and examples of the wiring board include a printed circuit board (PCB) of the printed wiring board. The printed circuit board may be, for example, a multilayer printed circuit board described above in "Interlayer Insulating Film". The printed circuit board encompasses all of a rigid board, a flexible board, a rigid flexible board, a metal-based board, and the like. An electronic component can be mounted on any of these printed circuit boards to form a printed wiring board.

### Fourth Embodiment: Printed Wiring Board

The printed wiring board according to the present embodiment includes the resin composition described above and an electronic component. The structure and/or application of the printed wiring board are not limited. For example, the printed wiring board may be any printed circuit board such as a rigid board, a flexible board, a rigid flexible board, or a metal-based board on which an electronic component is mounted.

Examples of the electronic component include, but are not limited to, a semiconductor chip, a resistor, and a capacitor. As a structure, for example, wiring and an electronic component may be mounted on one surface or both surfaces of a wiring board (printed circuit board), or wiring and an electronic component may be mounted between layers of a wiring board having a multilayer structure.

As applications, for example, a rigid printed wiring board in which an electronic component is mounted on a rigid board can be used in a terminal of a mobile communication system, a base station, a server, a router, a millimeter wave radar, a probe card, or the like, and a flexible printed wiring board in which an electronic component is mounted on a flexible board can be used in a connection cable, an antenna, an antenna cable, or the like.

### Fifth Embodiment: Method for Producing Wiring Board

The method for producing a wiring board according to the present embodiment includes:
curing a resin composition, the resin composition containing:
a substituted polyphenylene sulfide resin (A) that contains a structural unit represented by General Formula (I): 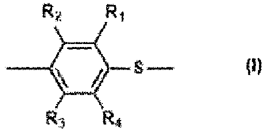
where R₁, R₂, R₃, and R₄ are each independently H, an alkyl group, an alkoxy group, an aryl group, or an alkenyl group-containing organic group (preferably H, an alkyl group, an alkoxy group, or an alkenyl group-containing organic group), and one or more of R₁, R₂, R₃, and R₄ are an alkyl group or an alkoxy group;
a filler (B); and
a styrene-based (co)polymer (D) and/or a radical polymerizable compound (E). The details of the resin composition are as described above.

Since the resin composition containing the styrene-based (co)polymer (D) and/or the radical polymerizable compound (E) can be cured at a low temperature, it can be cured at a lower temperature than when curing the substituted PPS resin (A) alone.

The curing includes heating the resin composition at a temperature of 240°C or less. The heating temperature is 240°C or less, preferably 235°C or less, more preferably 230°C or less, even more preferably 225°C or less, and particularly preferably 220°C or less.

The heating method is not limited, and heating can be performed using a known heating and drying device.

In one embodiment, the method for producing a wiring board may include preparing a varnish containing the resin composition and applying (or impregnating) the varnish to a base material prior to the curing. In another embodiment, the method for producing a wiring board may include preparing a prepreg containing the resin composition prior to the curing. The method for producing a wiring board may further include drying.

A non-limiting list of exemplary embodiments and combinations of exemplary embodiments of the present disclosure is disclosed below.
[1] A resin composition containing:
   a substituted polyphenylene sulfide resin (A) that contains a structural unit represented by General Formula (I): 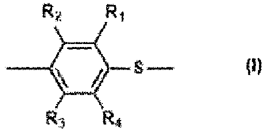
   where R₁, R₂, R₃, and R₄ are each independently H, an alkyl group, an alkoxy group, an aryl group, or an alkenyl group-containing organic group, and one or more of R₁, R₂, R₃, and R₄ are an alkyl group or an alkoxy group; and
   a filler (B).
[2] The resin composition according to [1], being impregnated into a glass cloth (C).
[3] The resin composition according to [1] or [2], further containing a styrene-based (co)polymer (D).
[4] The resin composition according to any one of [1] to [3], further containing a radical polymerizable compound (E).
[5] The resin composition according to any one of [1] to [4], further containing an organic peroxide (F).
[6] The resin composition according to any one of [1] to [5], in which the content of the substituted polyphenylene sulfide resin (A) and the content of the filler (B) are from 40 parts by mass to 200 parts by mass relative to 100 parts by mass of the substituted polyphenylene sulfide resin (A).
[7] The resin composition according to any one of [1] to [6], in which the substituted polyphenylene sulfide resin (A) contains a structural unit represented by General formula (II): 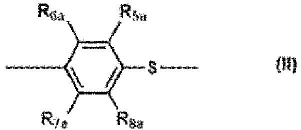 where R₅ₐ, R₆ₐ, R₇ₐ, and R₈ₐ are each independently H, an alkyl group, an alkoxy group, an aryl group, or an alkenyl group-containing organic group, and one or more of R₅ₐ, R₆ₐ, R₇ₐ, and R₈ₐ are an alkenyl group-containing organic group.
[8] The resin composition according to any one of [1] to [7], further containing a solvent.
[9] An article for a wiring board, the article containing the resin composition described in any one of [1] to [8].
[10] The article according to [9], being an interlayer insulating film, a prepreg, a metal-clad laminate, or a substrate.
[11] A wiring board containing the resin composition described in any one of [1] to [8].
[12] A printed wiring board containing:
   the resin composition described in any one of [1] to [8]; and
   an electronic component.

### Examples

The present disclosure will be described in more detail by way of Examples, but the interpretation of the present disclosure is not limited by the Examples.

### Synthesis Example 1: Preparation of MVPPS

Poly(2,6-dimethyl-1,4-phenylene sulfide) (285.0 g) produced in Synthesis Example 1, N-bromosuccinimide (NBS) (0.05 mol, 8.94 g), and AIBN (0.06 mol, 10.3 g) were added to a 20 L four-necked flask, dissolved in chlorobenzene, and then reacted under reflux for 24 hours. After the reaction, the solution was cooled with ice water, and the precipitated succinimide was filtered off with a glass filter. A filtrate was purified by precipitation with 5 wt.% hydrochloric acid-acidified methanol, recovered using a glass filter, and vacuum dried to produce bromo PPS (MXPPS) (yield: 85%, 853.3 g) in which some of protons of methyl groups were bromo-substituted. Subsequently, MXPPS (850 g) and triphenylphosphine (0.74 mol) were added to the four-necked flask and dissolved in THF, followed by heating under reflux for 24 hours. Thereafter, the reaction solution was cooled to room temperature, 37 wt.% aqueous formaldehyde solution (5.55 mol, 409 mL) was added thereto, and the mixture was stirred for 23 minutes. As a result, the precipitate disappeared. Subsequently, potassium t-butoxide (0.86 mol) was added and reacted for 17 hours. After the reaction was completed, the solution was concentrated to about 1/2, and purified by precipitation with hydrochloric acid-acidified methanol. Thereafter, the reaction product was collected by centrifugation and dried in vacuum to produce a 2,6-dimethyl PPS resin (MVPPS) having 7% of the total amount of methyl groups substituted with vinyl groups, corresponding to the substituted PPS resin (A) (yield: 95%, 810 g).

This substituted PPS resin (A) has the following structural units A and B.

The structural unit A: in General Formula (I), R₁ or R₄ (R₅ₐ or R₈ₐ in General Formula (II)) is a methyl group, R₁ or R₄ which is not a methyl group (R₅ₐ or R₈ₐ in General Formula (II)) is a vinyl group, and R₂ and R₃ (R₆ₐ or R₇ₐ in General Formula (II)) is H.

The structural unit B: in General Formula (I), R₁ and R₄ are methyl groups, and R₂ and R₄ are H.

The content of the structural unit A (the structural unit containing a vinyl group and a methyl group) is 2 mol% in the substituted PPS resin, and the content of the structural unit B (the structural unit containing a methyl group) is 98 mol% in the substituted PPS resin.

For the resulting polymer, the weight-average molecular weight (Mw) and the number-average molecular weight (Mn) in terms of polystyrene were measured by gel permeation chromatography (GPC), and the Mw was 30000 and the Mn was 8600.

### Materials

Materials used in Examples and Comparative Examples are shown below.

### Main Agent

A1: Polyphenylene ether (PPE), "SA9000" manufactured by ABIC
A2: Polymer produced in Synthesis Example 1 (VDMPPS: 2,6-dimethyl PPS resin having 7% of methyl groups substituted with vinyl groups)

### Filler

B1: Silica filler (vinyl silane treated, particle size of 0.5 µm, manufactured by ADMATECHS COMPANY LIMITED)

### Glass Cloth

C1: NE-1078 (manufactured by Nitto Boseki Co., Ltd.)

### Styrene-Based (Co)Polymer

D1: Styrene-ethylene/butadiene-styrene (SEBS), "TUFTEC (trade name) P5051" manufactured by Asahi Kasei Corp., styrene ratio (catalog value) of 49 mass%

### Radical Polymerizable Compounds

E1: Triallyl isocyanurate, "TAIC" manufactured by Nihon Kasei CO., LTD., molecular weight of 249.7

### Organic Peroxide

F1: 1,3-bis(butylperoxyisopropyl)benzene ("Perbutyl P" manufactured by NOF CORPORATION)

### Solvent

Toluene

### Example 1

The VMPPS (12.0 g) produced in Synthesis Example 1 was dissolved in toluene (30 g). Further, a styrene-based thermoplastic elastomer D1 (TUFTEC (trade name) P5051, manufactured by Asahi Kasei Corp., 7.2 g), an organic peroxide F1 (Perbutyl P, manufactured by NOF CORPORATION, 0.19 g), and a filler B1 (5SP-CT1, manufactured by ADMATECHS COMPANY LIMITED, 70 wt.% in toluene, 36.2 g) were added thereto, and the mixture was stirred at 50°C for 2 hours to produce a varnish, which was a resin composition.

### Drying

The resulting varnish was poured into a metal pad, and a glass cloth (22 mass% of glass cloth relative to 100 mass% of the resin composition excluding toluene) cut 16 cm wide and 25 cm long was impregnated with the varnish. After the impregnation, the glass cloth was dried at 100°C for 2 minutes and at 140°C for 5 minutes to prepare a prepreg.

### Curing

The resulting prepreg was sandwiched between Teflon sheets and pressed with a press machine to prepare a cured product. The pressing conditions were as follows: the temperature was held at 100°C for 20 minutes, the temperature was raised to 200°C at 5°C/min, and the temperature was held at 200°C for 90 minutes. The pressure was held at 100°C for 20 minutes followed by a rise to 4 MPa.

### Example 2

### Drying

A varnish was prepared in the same manner as in Example 1, and then poured into a Teflon petri dish and dried on a hot plate at 120°C for 5 minutes. The resulting film-like solid was crushed and dried again on a hot plate at 120°C for 5 minutes to produce a powder solid.

### Curing

The powder solid (about 1 g) produced in the drying and a polyimide film of 120 µm as a spacer were sandwiched between Teflon films, and the resulting product was vacuum-pressed by a vacuum press machine. The temperature was raised from 80°C at a rate of 20°C/min and held at 200°C for 2 hours. A pressure of 10 kN was applied when the temperature of the heating plate reached 110°C, thereby producing a film-like cured product having a thickness of about 100 µm and a diameter of about 10 cm.

### Comparative Example 1

A cured product of the resin composition was produced in the same manner as in Example 1 except that polyphenylene ether (PPE) was used instead of VMPPS with the blending amounts shown in Table 1.

### Comparative Example 2

A cured product of the resin composition was produced in the same manner as in Example 2 except that polyphenylene ether (PPE) was used instead of VMPPS with the blending amounts shown in Table 1.

In Comparative Example 3, the VMPPS powder produced in Synthesis Example 1 was used as it was, without undergoing the drying, to produce a film-like cured product.

Specifically, the VMPPS powder produced in Synthesis Example 1 and a polyimide film having a thickness of 120 µm as a spacer were sandwiched between Teflon films, and the resultant was vacuum-pressed by a vacuum press machine. The temperature was raised from 160°C at a rate of 20°C/min, and held at 245°C for 2 hours. A pressure of 5 kN was applied when the temperature of the heating plate reached 235°C, thereby producing a film-like cured product having a thickness of about 100 µm and a diameter of about 10 cm.

### Evaluation

Various physical properties were measured by the following methods. The results are shown in Table 1.

### Measurement of Dielectric Loss Tangent

The dielectric loss tangent was measured using the film-like cured products produced by the above method. The dielectric loss tangent was measured at 10 GHz or 40 GHz by a cavity resonator perturbation method under conditions of a standard environment (23 ± 2°C) and a relative humidity of from 45 to 55% by means of a vector network analyzer (N5290A) and a split cylinder resonator, both available from Keysight Technologies.

### Thermal Expansion Coefficient

The coefficient of linear thermal expansion (α1 (in a region lower than Tg)) of the film-like cured products produced by the above method was determined from a strain-temperature curve obtained under the following conditions.
Measurement equipment: TMA SS7100/Hitachi High-Tech Science Corporation
Measurement Mode: Tensile
Atmosphere: N₂
Temperature range: 1st heat/0°C to 250°C
2nd heat/0°C to 250°C
Wait for 20 minutes at the start temperature
Temperature increase rate: 5°C/min
Measurement load: 20 mN

A case where the thermal expansion coefficient was 60 ppm/K or less was evaluated as "fair", a case where the thermal expansion coefficient was 30 ppm/K or less was evaluated as "excellent", and a case where the thermal expansion coefficient was higher than 60 ppm/K was evaluated as "poor".

**[Table 1]**

| | | | Examples | | Comparative Examples | | |
|---|---|---|---|---|---|---|---|
| | | | Example 1 | Examples 2 | Comparative Example 1 | Comparative Example 2 | Comparative Example 3 |
| | (A) Main agent | A1 | | | 50 | 50 | |
| | | A2 | 50 | 50 | | | 100 |
| | (B) Filler | B1 | 40 | 40 | 40 | 40 | |
| | (C) Glass cloth | C1 | Used | - | Used | - | - |
| Formulation (mass%) | (D) Styrene-based (co)polymer | D1 | 30 | 30 | 30 | 30 | |
| | (E) Radical polymerizable compound | E1 | | | | | |
| | (F) Organic peroxide | F1 | 0.8 | 0.8 | 0.8 | 0.8 | 0 |
| | Solvent | Toluene | 100 | 100 | 100 | 100 | 0 |
| | Dielectric loss tangent | Dielectric loss tangent_10 GHz | 0.00178 | 0.00165 | 0.00262 | 0.00278 | 0.00117 |
| | | Dielectric loss tangent_40 GHz | 0.00227 | 0.00195 | 0.00322 | 0.00345 | 0.00172 |
| | | Dielectric loss tangent of 0.002 or less (10 GHz) | 0.002 or less | 0.002 or less | More than 0.002 | More than 0.002 | 0.002 or less |
| | Thermal expansion coefficient (CTE) | Average value of CTE from 50°C to 150°C | 17 ppm/K | 45 ppm/K | 29 ppm/K | 47 ppm/K | 85 ppm/K |
| | | Excellent/Fair/Poor | Excellent | Fair | Excellent | Fair | Poor |

As shown in Table 1, the film-like cured products containing a VMPPS and a filler (Examples 1 and 2) had a dielectric loss tangent of 0.002 or less at 10 GHz and a dielectric loss tangent of 0.0025 or less at 40 GHz.

On the other hand, the film-like cured products containing polyphenylene ether (PPE) and a filler (Comparative Examples 1 and 2) had a dielectric loss tangent of more than 0.002 at 10 GHz and a dielectric loss tangent of more than 0.003 at 40 GHz.

The above results revealed that the dielectric loss tangent of the film-like cured products tends to be low when the VMPPS is contained in the resin composition.

In addition, the thermal expansion coefficients of the film-like cured products containing VMPPS and a filler (Examples 1 and 2) were evaluated as fair or excellent. The thermal expansion coefficient of the film-like cured product (Example 1) containing glass cloth in addition to VMPPS and the filler was evaluated as excellent.

The thermal expansion coefficients of the film-like cured products containing polyphenylene ether (PPE) and a filler (Comparative Examples 1 and 2) were also evaluated as fair or excellent. The thermal expansion coefficient of the film-like cured product (Comparative Example 1) containing a glass cloth in addition to the polyphenylene ether (PPE) and the filler was evaluated as excellent.

On the other hand, the thermal expansion coefficient of the film-like cured product containing VMPPS and not containing a filler or glass cloth (Comparative Example 3) was evaluated as poor.

The above results revealed that the thermal expansion coefficients of the film-like cured products are likely to be low when the resin composition contains a filler or a glass cloth. Particularly, the thermal expansion coefficients of the film-like cured products are more likely to be low when a filler and a glass cloth are contained in the film-like cured products.

It was shown that the film-like cured products tend to have a low dielectric loss tangent and a low thermal expansion coefficient when the VMPPS and the filler or the glass cloth are contained in the resin composition.

### Industrial Applicability

The resin composition of the present embodiment has a low dielectric loss tangent and a low thermal expansion coefficient, and can therefore be preferably used for the production of wiring boards, and has industrial applicability.

## Claims

1. A resin composition comprising:
a substituted polyphenylene sulfide resin (A) that includes a structural unit represented by General Formula (I): 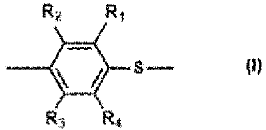
where R₁, R₂, R₃, and R₄ are each independently H, an alkyl group, an alkoxy group, an aryl group, or an alkenyl group-containing organic group, and one or more of R₁, R₂, R₃, and R₄ are an alkyl group or an alkoxy group; and
a filler (B).

2. The resin composition according to claim 1, being impregnated into a glass cloth (C).

3. The resin composition according to claim 1, further comprising a styrene-based (co)polymer (D).

4. The resin composition according to claim 1, further comprising a radical polymerizable compound (E).

5. The resin composition according to claim 1, further comprising an organic peroxide (F).

6. The resin composition according to claim 1, wherein a content of the substituted polyphenylene sulfide resin (A) and a content of the filler (B) are from 40 parts by mass to 200 parts by mass relative to 100 parts by mass of the substituted polyphenylene sulfide resin (A).

7. The resin composition according to claim 1, wherein the substituted polyphenylene sulfide resin (A) includes a structural unit represented by General formula (II): 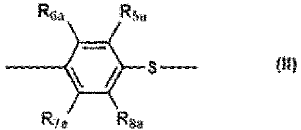 where R₅ₐ, R₆ₐ, R₇ₐ, and R₈ₐ are each independently H, an alkyl group, an alkoxy group, an aryl group, or an alkenyl group-containing organic group, and one or more of R₅ₐ, R₆ₐ, R₇ₐ, and R₈ₐ are an alkenyl group-containing organic group.

8. The resin composition according to any one of claims 1 to 7, further comprising a solvent.

9. An article for a wiring board, the article comprising the resin composition described in any one of claims 1 to 7.

10. The article according to claim 9, being an interlayer insulating film, a prepreg, a metal-clad laminate, or a substrate.

11. A wiring board comprising the resin composition described in any one of claims 1 to 7.

12. A printed wiring board comprising:
the resin composition described in any one of claims 1 to 7; and
an electronic component.
